(19)

**Europäisches Patentamt**
**European Patent Office**
**Office européen des brevets**

(11) **EP 2 959 305 B1**

(12) **FASCICULE DE BREVET EUROPEEN**

(45) Date de publication et mention de la délivrance du brevet:
**05.04.2017 Bulletin 2017/14**

(21) Numéro de dépôt: **14711808.7**

(22) Date de dépôt: **18.02.2014**

(51) Int Cl.:
**G01R 33/385** *(2006.01)*     **G01R 33/3875** *(2006.01)*
**G01R 33/565** *(2006.01)*     **G01R 33/30** *(2006.01)*

(86) Numéro de dépôt international:
**PCT/FR2014/050335**

(87) Numéro de publication internationale:
**WO 2014/128399 (28.08.2014 Gazette 2014/35)**

(54) **PROCEDE ET DISPOSITIF DE CORRECTION DE CHAMP MAGNETIQUE POUR UNE MACHINE DE RMN**

VERFAHREN UND VORRICHTUNG ZUR MAGNETFELDKORREKTUR FÜR EINE NMR-MASCHINE

METHOD AND DEVICE FOR MAGNETIC FIELD CORRECTION FOR AN NMR MACHINE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **19.02.2013 FR 1351396**

(43) Date de publication de la demande:
**30.12.2015 Bulletin 2015/53**

(73) Titulaire: **Commissariat à l'Energie Atomique et aux Energies Alternatives**
**75015 Paris (FR)**

(72) Inventeurs:
• **SAKELLARIOU, Dimitri**
**F-92100 Boulogne Billancourt (FR)**
• **HUGON, Cedric**
**F-38470 Teche (FR)**
• **AUBERT, Guy**
**F-86000 Poitiers (FR)**

(74) Mandataire: **Desormiere, Pierre-Louis et al**
**Cabinet Beau de Loménie**
**158, rue de l'Université**
**75340 Paris Cedex 07 (FR)**

(56) Documents cités:
**US-A- 4 840 700     US-A1- 2003 112 107**

• **SODICKSON A ET AL: "Shimming a High-Resolution MAS Probe", JOURNAL OF MAGNETIC RESONANCE, ACADEMIC PRESS, ORLANDO, FL, US, vol. 128, no. 1, 1 septembre 1997 (1997-09-01), pages 87-91, XP004407861, ISSN: 1090-7807, DOI: 10.1006/JMRE.1997.1218**
• **NISHIYAMA Y ET AL: "MAGIC SHIMMING: Gradient shimming with magic angle sample spinning", JOURNAL OF MAGNETIC RESONANCE, ACADEMIC PRESS, ORLANDO, FL, US, vol. 216, 1 mars 2012 (2012-03-01), pages 197-200, XP002685302, ISSN: 1090-7807, DOI: DOI:10.1016/J.JMR.2012.02.001 [extrait le 2012-02-11]**

**Description**

Domaine de l'invention

La présente invention a pour objet un procédé et un dispositif de correction de champ magnétique, pouvant être utilisés notamment dans la technique permettant de créer des spectres et des images par résonance magnétique nucléaire (RMN), cette technique étant également connue sous le nom d'imagerie par résonance magnétique (IRM).
L'invention concerne également un système d'imagerie par résonance magnétique mettant en oeuvre un tel procédé de correction de champ magnétique.

Art antérieur

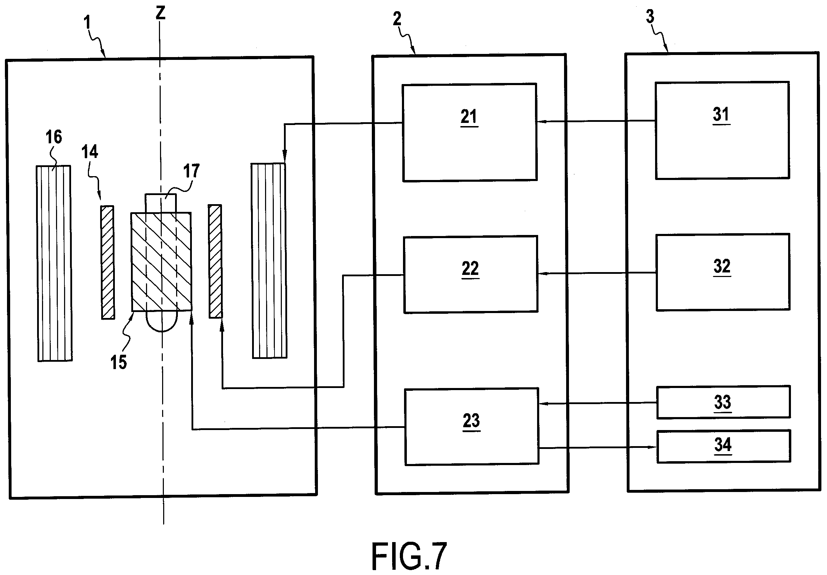

L'IRM et la RMN reposent sur l'utilisation de champs magnétiques, dont un champ magnétique dit « *principal»* qui doit être aussi uniforme que possible dans la région examinée ou zone d'intérêt ZI. L'usage a consacré le qualificatif « *homogène* » pour désigner ce caractère uniforme. Ce champ magnétique de grande homogénéité est généré par des aimants dont les plus répandus aujourd'hui sont constitués de bobinages supraconducteurs qui transportent les courants électriques générant le champ sans aucune dissipation d'énergie, à condition qu'ils soient maintenus à très basse température. Un tel dispositif d'aimant a généralement l'apparence extérieure d'un tunnel cylindrique dans lequel on introduit l'objet ou le patient à imager.
L'analyse d'échantillons anisotropes, par exemple des solides, par RMN nécessite de faire tourner l'échantillon autour d'un axe orienté à l'angle dit "magique" (arctan($\sqrt{2}$) ~ 54,7°). L'échantillon est généralement de forme cylindrique, et sa longueur est souvent largement plus grande que son diamètre (entre un facteur 2 et un facteur 10). Ce rapport de forme est aussi retrouvé dans la RMN d'échantillons isotropes, par exemple des liquides, où, typiquement, l'échantillon est contenu dans un tube de 5 mm de diamètre et la hauteur d'échantillon dans le tube se situe plutôt de l'ordre du centimètre ou plus.
La spectroscopie RMN, qu'elle soit de l'état anisotrope (solide) ou de l'état isotrope (liquide), nécessite un champ magnétique ambiant extrêmement uniforme dans l'espace. L'analyse des échantillons se fait en effet par l'analyse du spectre RMN, qui est constitué par la réponse en fréquence de l'échantillon lorsqu'il est excité par des impulsions radiofréquence (RF). Cette réponse dépend directement de la valeur locale du champ magnétique. La fréquence de réponse locale (c'est-à-dire celle d'un noyau atomique donné) est appelée fréquence de Larmor ($f_{Larmor}$) et est donnée par

$$f_{Larmor} = \gamma B_0, \ (1)$$

où $\gamma$ est le rapport gyromagnétique fréquentiel du noyau et $B_0$ est le module du champ magnétique statique local. Cette valeur locale peut être affectée par la composition chimique de l'échantillon, ce qui permet de révéler des informations cruciales sur la nature, la composition et les propriétés de l'échantillon. L'ordre de grandeur des interactions qui affectent le spectre RMN est la partie par million (ppm). Ceci implique que le champ magnétique ambiant doit lui-même être bien plus homogène que 1 ppm sur toute l'étendue de l'échantillon.
On conçoit pour cela des aimants spécifiquement configurés qui produisent un champ extrêmement homogène, mais rarement suffisamment pour permettre la spectroscopie sans ajustements supplémentaires. Ceci est d'autant plus vrai que l'échantillon lui-même est souvent à l'origine de distorsions du champ magnétique à cause de sa susceptibilité magnétique intrinsèque.
On est donc obligé d'avoir recours à des bobines spécifiques de correction de champ magnétique, dites "bobines de shim", qui permettent de compenser les dernières imperfections de l'aimant afin d'obtenir l'uniformité nécessaire. Chaque aimant de RMN "standard", que ce soit pour le liquide ou le solide, est donc équipé de ce que l'on appelle un "fourreau de shims" qui n'est autre qu'un ensemble de bobines de correction de champ magnétique (bobines de shim) dont les courants peuvent être pilotés indépendamment. L'ajustement du courant permet de contrôler l'effet de chaque bobine sur la distribution spatiale du champ. Le fourreau de shims est généralement un objet cylindrique d'épaisseur modérée afin d'occuper le minimum de place dans le trou de l'aimant. Il est bien sûr coaxial avec le trou de l'aimant.
On a représenté de façon schématique sur la figure 7 un exemple de spectromètre de RMN mettant en oeuvre des bobines de correction de champ magnétique.
Un tel spectromètre comprend une unité d'expérimentation 1, une unité d'activation 2 comprenant un ensemble de composants électroniques et une unité de commande 3 comprenant un ordinateur ou processeur de traitement.
L'unité d'expérimentation 1 comprend, à l'intérieur du trou cylindrique d'un aimant (non représenté) de création du champ magnétique principal, d'axe z, un échantillon 17, autour duquel sont disposées des bobines radiofréquence 15, elles-mêmes entourées de bobines de gradient 14 et de bobines 16 de correction de champ magnétique (bobines de shim).

L'unité d'activation 2 comprend une unité 21 d'alimentation des bobines de shim 16, une unité 22 d'alimentation des bobines de gradient 14, une unité 23 d'émission de signaux RF vers les bobines RF 15 et de réception des signaux RF émis par les bobines RF 15.

L'unité de commande 3 comprend un module 31 de détermination des valeurs des signaux à fournir par l'unité 21 d'alimentation des bobines de shim 16, un module 32 de détermination des valeurs des signaux à fournir par l'unité 22 d'alimentation des bobines de gradient 14, un module 33 d'envoi d'impulsions RF vers l'unité 23 reliée aux bobines RF 15 et un module 34 de réception de signaux de RMN radiofréquence fournis par l'unité 23 reliée aux bobines RF 15.

L'obtention d'un champ magnétique hautement uniforme est une tâche complexe. Afin de simplifier le problème, on a recours à une approximation majeure. Celle-ci consiste à considérer que, dans un champ homogène, les variations du module du champ magnétique sont dominées par celle de la composante principale du champ. Dans le cas des aimants supraconducteurs, le champ est généralement vertical dans le référentiel du laboratoire. On a donc pris l'habitude d'assimiler la quantité $B_0$ à $B_z$, la composante verticale du champ magnétique. On peut alors montrer que les variations de $B_0$ sont dominées par celles de $B_z$, tant que ces variations sont faibles comparées à la valeur du champ à l'origine.

Cette approximation permet donc de ne considérer qu'une composante cartésienne du champ magnétique. Il est possible de montrer que, dans une région vide de sources de champ magnétique, cette composante peut être développée en série d'harmoniques sphériques. On peut ainsi écrire de manière générale, dans le système de coordonnées sphériques $(r, \vartheta, \varphi)$, et dans la sphère intérieure aux sources :

$$B_z = Z_0 + \sum_{n=1}^{\infty} r^n \left[ Z_n P_n \left( \cos \vartheta \right) + \sum_{m=1}^{n} \left( X_n^m \cos m\varphi + Y_n^m \sin m\varphi \right) P_n^m \left( \cos \vartheta \right) \right]$$

(2)

où $(r, \vartheta, \varphi)$ sont les coordonnées sphériques du point considéré dans un repère d'axe $Oz$ tel que $z = r\cos\vartheta$ avec $x = r\sin\vartheta\cos\varphi$ et $y = r\sin\vartheta\sin\varphi$. Les $P_n$ sont les polynômes de Legendre de degré $n$ et les $P_n^m$ sont les polynômes de Legendre associés de degré $n$ et d'ordre $m$. Ce développement est unique et valable à l'intérieur de la plus grande boule de centre $O$ magnétiquement vide.

Si la configuration des sources de champ est axisymétrique d'axe $Oz$, on obtient la forme simple suivante :

$$B_z = Z_0 + \sum_{n=1}^{\infty} r^n Z_n P_n \left( \cos \vartheta \right)$$

(2.1)

C'est la forme appropriée pour un ensemble de spires coaxiales d'axe $Oz$. Elle se réduit à une forme encore plus simple pour $B_z(z)$ sur l'axe, soit :

$$B_z = Z_0 + \sum_{n=1}^{\infty} Z_n z^n$$

(2.2)

Les termes $Z_n$, $X_n^m$, et $Y_n^m$ sont des termes définis par la géométrie des sources de champ.

L'équation fondamentale (2) susmentionnée fournit l'outil nécessaire à la résolution du problème de l'homogénéité. En effet, à l'intérieur de la sphère intérieure (i.e. la plus grande sphère ne contenant aucune source de champ), les variations du champ dues à un terme $C_n$ (c'est-à-dire $Z_n$, $X_n^m$, ou $Y_n^m$) de degré n sont en $C_n r^n$.

Or on montre (par analyse dimensionnelle ou calcul direct) que $C_n$ varie comme $1/r_0^n$. Si $r_s$ est la plus grande distance d'un point de l'échantillon à l'origine, la contribution du terme $C_n$ au champ variera comme $C_n(r_s/r_0)^n$. Pour un échantillon de taille donnée ($r_s < r_0$), il suffit donc de compenser les termes de degrés les plus faibles jusqu'à un degré $n_0$ suffisant pour pouvoir obtenir l'homogénéité désirée sur un volume donné.

On se base ainsi sur ce concept pour concevoir les bobines de shim. Chacune de ces bobines est supposée traiter un terme particulier du développement en harmoniques sphériques (DHS). Par ailleurs, la forme de l'échantillon utilisée en RMN du liquide amène à privilégier les termes "axiaux" ($Z_n$) puisque l'échantillon est plus étendu le long de l'axe. On trouve ainsi, référencées par l'écriture en coordonnées cartésiennes de chaque terme, des bobines "$Z_1$", "$Z_2$", "$Z_3$", « $Z_4$ », "ZX", "X", "Y", etc. On notera que les termes axiaux montent souvent jusqu'au degré 4 ou supérieur mais les termes non axiaux sont souvent limités au degré 3 ou moins.

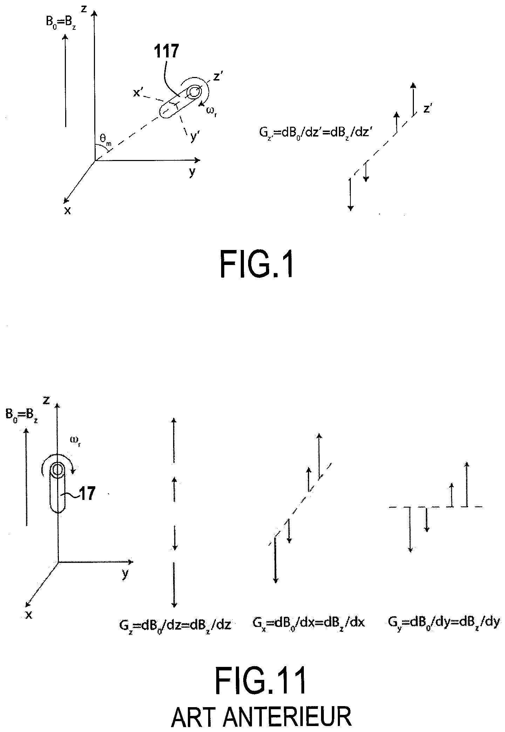

Un schéma simplifié de l'état de l'art en spectroscopie haute résolution par RMN est présenté sur la Figure 11. On observe l'échantillon 17 placé le long de l'axe z, qui peut tourner autour de cet axe avec une fréquence $\omega_r$ afin de moyenner les inhomogénéités résiduelles du champ magnétique dues aux termes non axiaux ($X_n^m$ et $Y_n^m$). Les bobines de shim sont conçues pour effectuer des corrections sur les termes du DHS par rapport au système des coordonnées du laboratoire *Oxyz.*

La RMN du solide a modifié la configuration standard en RMN du liquide en plaçant l'échantillon de forme cylindrique le long d'un axe incliné à l'angle magique par rapport à la verticale (direction du champ). Par contre, l'instrumentation est restée identique et les bobines de shim sont restées référencées dans le laboratoire. Il faut donc effectuer un changement de référentiel pour trouver le DHS rattaché au référentiel incliné à l'angle magique à partir du DHS attaché au référentiel du laboratoire. On a ainsi besoin de plus de termes non axiaux pour permettre de compenser le champ le long de cet axe incliné. La procédure nécessite d'utiliser jusqu'à huit bobines de shim pour permettre de compenser les termes $Z'_1$, $Z'_2$, et $Z'_3$ dans le référentiel de l'échantillon (c'est-à-dire avec un axe Oz' à l'angle magique avec l'axe de Bz).

Afin de corriger à un degré supérieur à 4, il faudrait combiner encore plus de bobines dans le référentiel du laboratoire, lesquelles bobines n'existent pas dans les fourreaux de shim commerciaux, et dont l'efficacité serait très faible.

Définition et objet de l'invention

La présente invention vise à remédier aux inconvénients précités et à permettre la réalisation de façon simplifiée d'un dispositif de correction d'homogénéité d'un champ magnétique pour un système de spectroscopie ou d'imagerie par résonance magnétique.

L'invention vise encore à définir un procédé de réalisation d'un tel dispositif qui soit simplifié et permette néanmoins une optimisation de l'homogénéisation du champ magnétique créé dans le volume d'intérêt.

Ces buts sont atteints, conformément à l'invention, grâce à un procédé de correction de champ magnétique d'un système d'imagerie par résonance magnétique tel que défini par la revendication 1, ledit système comprenant un dispositif de création d'un champ magnétique principal selon une direction Oz, dans une zone d'intérêt ZI, un dispositif de support d'un échantillon, avec une orientation d'une dimension principale de l'échantillon selon un angle $\theta_0$ différent de zéro par rapport à ladite direction Oz, des bobines de gradient, et des bobines radiofréquence et la correction étant effectuée à l'aide de bobines de correction disposées autour dudit dispositif de support de l'échantillon, comprenant les étapes suivantes :

- définir un système de coordonnées incliné Ox'y'z' attaché à l'échantillon avec un axe principal Oz' correspondant à ladite dimension principale de l'échantillon,
- déterminer par un développement en harmoniques sphériques dans ledit système de coordonnées incliné Ox'y'z' attaché à l'échantillon la forme des bobines de correction à partir d'une fonction flux F, chaque bobine de correction correspondant à un terme du développement en harmoniques sphériques, et la fonction flux F étant telle que l'on obtient une distribution de courant minimisant la puissance dissipée pour une valeur d'un terme axial Z'n donné lorsque la fonction F est solution d'une équation de Poisson,
- tracer pour chaque bobine de correction des iso-contours de la fonction flux F espacés de manière régulière entre des bornes de la fonction flux F sur un cylindre en incluant zéro s'il y a changement de signe, et
- former à partir des iso-contours du cylindre de chaque bobine de correction des éléments de bobinage pour définir ladite bobine cylindrique de correction positionnée autour du dispositif de support de l'échantillon, l'axe de ladite bobine cylindrique étant confondu avec ladite direction Oz.

Selon un mode de réalisation avantageux, ledit angle $\theta_0$ différent de zéro correspond à un angle dit magique égal à arctan ($\sqrt{2}$) ∼ 54,7°.

Selon un mode de réalisation particulier qui est à la fois simple et performant, on définit des première, deuxième et troisième bobines de correction correspondant respectivement à des termes axiaux $Z'_1$, $Z'_2$, $Z'_3$ du développement en harmoniques sphériques dans ledit système de coordonnées incliné Ox'y'z' attaché à l'échantillon.

Avantageusement, on alimente chacune des bobines de correction à l'aide d'un courant dont la valeur est ajustable.

L'invention concerne également un dispositif de correction de champ magnétique d'un système d'imagerie par résonance magnétique tel que défini par la revendication 5, ledit système comprenant un dispositif de création d'un champ magnétique principal selon une direction Oz, dans une zone d'intérêt ZI, un dispositif de support d'un échantillon, avec une orientation d'une dimension principale de l'échantillon selon un angle $\theta_0$ différent de zéro par rapport à ladite direction Oz, des bobines de gradient et des bobines radiofréquence, ledit dispositif de correction de champ magnétique comprenant un ensemble de bobines de correction positionnées autour du dispositif de support de l'échantillon, caractérisé en ce que chaque bobine de correction présente un axe confondu avec la direction Oz et comprend des éléments de bobinage réalisés à partir des iso-contours d'une fonction flux F espacés de manière régulière entre des bornes de la fonction flux F sur un cylindre, la forme des iso-contours étant déterminée à partir d'un développement en harmoniques sphériques dans un système de coordonnées incliné Ox'y'z' attaché à l'échantillon avec un axe principal Oz' correspondant à ladite dimension principale de l'échantillon, chaque bobine de correction correspondant à un terme du développement en harmoniques sphériques, la fonction flux F étant telle que l'on obtient une distribution de courant minimisant la puissance dissipée pour une valeur d'un terme axial $Z'_n$ donné lorsque la fonction $F$ est solution d'une équation de Poisson.

Avantageusement, ledit angle $\theta_0$ différent de zéro correspond à un angle dit magique égal à arctan ($\sqrt{2}$) ~ 54,7°.

Selon un mode de réalisation préférentiel, l'ensemble de bobines de correction comprend des première, deuxième et troisième bobines de correction correspondant respectivement à des termes axiaux $Z'_1$, $Z'_2$, $Z'_3$ du développement en harmoniques sphériques dans ledit système de coordonnées incliné Ox'y'z' attaché à l'échantillon.

L'invention concerne encore un système d'imagerie par résonance magnétique tel que défini par la revendication 9, comprenant un dispositif de création d'un champ magnétique principal selon une direction Oz, dans une zone d'intérêt ZI, un dispositif de support d'un échantillon, avec une orientation d'une dimension principale de l'échantillon selon un angle $\theta_0$ différent de zéro par rapport à ladite direction Oz, des bobines de gradient et des bobines radiofréquence, caractérisé en ce qu'il comprend un dispositif de correction de champ magnétique tel que défini ci-dessus.

Ladite direction Oz peut notamment être verticale ou horizontale, selon les applications envisagées.

On notera que favoriser les termes le long de l'axe à l'angle magique, comme selon des modes préférentiels de réalisation de l'invention, est d'autant plus pertinent que la rotation de l'échantillon dans une expérience de rotation à l'angle magique (en anglais « Magic Angle Spinning » ou « MAS ») atteint des vitesses de l'ordre de 10 kHz ou plus, ce qui a pour effet d'annuler l'influence, même importante, des termes non axiaux. Par conséquent, se placer dans le référentiel incliné pour traiter les termes du DHS de la composante de champ magnétique $B_z$ est extrêmement important et efficace.

Selon des modes particuliers de réalisation, les éléments de bobinage des bobines de correction peuvent comprendre par exemple des pistes ou fils conducteurs sur des supports isolants.

Brève description des dessins

D'autres caractéristiques et avantages de l'invention ressortiront de la description suivante de modes particuliers de réalisation de l'invention donnés à titre d'exemples en référence aux dessins annexés, sur lesquels :

- La Figure 1 représente une vue schématique de la position d'un échantillon pour un système de spectroscopie RMN, auquel est applicable un dispositif de correction de champ magnétique selon l'invention,
- La Figure 2 montre une vue schématique en coupe axiale, d'un exemple de dispositif de support d'échantillon permettant une inclinaison de cet échantillon et le support d'un dispositif de correction de champ magnétique selon l'invention,
- La Figure 3 montre, sous une forme développée dans un plan, un exemple des iso-contours de la fonction flux pour une bobine cylindrique correctrice générant un profil de champ dominé par le terme axial $Z'_1$ d'un DHS et dont la puissance dissipée pour une valeur donnée de $Z'_1$ est minimum,
- La Figure 4 montre, sous une forme développée dans un plan, un exemple des iso-contours de la fonction flux pour une bobine cylindrique correctrice générant un profil de champ dominé par le terme axial $Z'_2$ d'un DHS et dont la puissance dissipée pour une valeur donnée de $Z'_2$ est minimum,
- La Figure 5 montre, sous une forme développée dans un plan, un exemple des iso-contours de la fonction flux pour une bobine cylindrique correctrice générant un profil de champ dominé par le terme axial $Z'_3$ d'un DHS et dont la puissance dissipée pour une valeur donnée de $Z'_3$ est minimum,
- La Figure 6 est un schéma-bloc simplifié d'un exemple de système de spectroscopie ou d'imagerie par résonance magnétique mettant en oeuvre un dispositif de correction de champ magnétique selon l'invention,
- La Figure 7 représente une vue schématique d'un exemple de système de spectroscopie et d'imagerie par résonance magnétique connu,
- La figure 8 montre un exemple de masque pour la fabrication d'un exemple de bobine de correction de gradient $G_x$,
- La figure 9 montre un exemple de masque pour la fabrication d'un exemple de bobine de correction de gradient $G_y$,
- La figure 10 montre un exemple de masque pour la fabrication d'un exemple de bobine de correction de gradient $G_z$, et
- La Figure 11 représente une vue schématique de la position d'un échantillon pour un système connu de spectroscopie RMN.

Description détaillée de modes de réalisation préférentiels

Selon la présente invention, on propose des bobines de correction de champ magnétique ou bobines de « shim », destinées à prendre en compte de façon préférentielle dans un développement en harmoniques sphériques (DHS) respectivement les termes axiaux $Z'_1$, $Z'_2$ et $Z'_3$, le dispositif de correction comprenant lesdites bobines étant conçu spécifiquement pour l'application à un système d'imagerie par résonance magnétique comprenant un échantillon incliné par rapport à la direction du champ magnétique principal en étant orienté selon un angle $\theta_0$ qui est de préférence égal à l'angle magique (54,7°).

Ces bobines s'inscrivent toujours sur un cylindre coaxial avec le trou de l'aimant créant le champ principal, et peuvent avoir les mêmes dimensions que les fourreaux contenant des bobines de correction (dits « fourreaux de shim ») déjà en service, permettant leur utilisation directe dans des installations existantes. Elles corrigent directement les termes du DHS attachés au référentiel incliné. On réduit ainsi de manière radicale le travail de l'opérateur qui doit procéder à des corrections des irrégularités du champ magnétique principal créé par son aimant.

Il est fait référence ici à des termes axiaux $Z'_1$, $Z'_2$ et $Z'_3$ jusqu'au degré 3, car ils sont considérés comme les plus importants, mais l'invention n'est bien sûr aucunement limitée à ce nombre et le procédé selon l'invention permet de calculer les caractéristiques de bobines compensant d'autres termes, de degré plus élevé ou même des termes non axiaux.

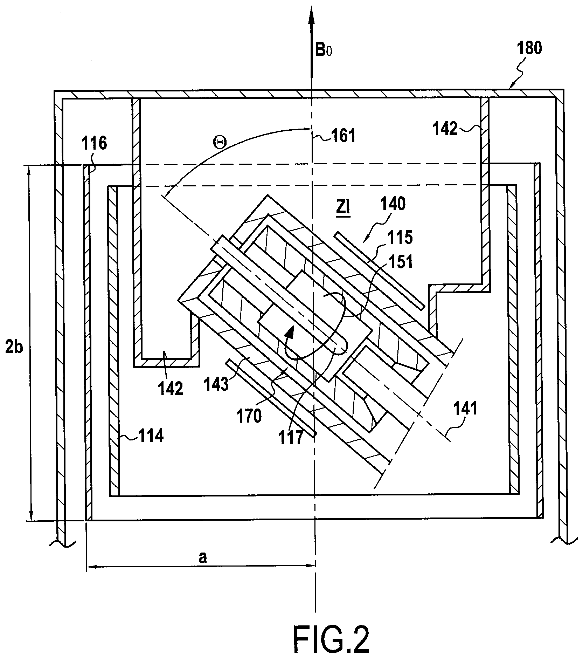

Un schéma simplifié du contexte d'application de l'invention est présenté sur la Figure 1. On observe l'échantillon 117 placé le long de l'axe z' qui se trouve à l'angle magique par rapport à l'axe z du champ magnétique $B_0$. L'échantillon 117 peut tourner autour de cet axe z' avec une fréquence $\omega_r$ afin de moyenner les interactions anisotropes et les inhomogénéités résiduelles du champ. Les bobines de correction 116 (Figure 2) sont dessinées pour effectuer des corrections sur les termes du DHS rattaché au système de coordonnées incliné $Ox'y'z'$.

On décrira ci-dessous un exemple de calcul des caractéristiques de bobines de correction 116 selon l'invention.

On commence par restreindre la zone d'existence des courants à une surface cylindrique de rayon $a$ et de longueur $2b$. Il s'agit ici d'une situation statique et l'on a donc

$$\nabla \cdot \vec{j} = 0, \tag{3}$$

où $\vec{j}$ est la densité de courant.

On a de plus, de nouveau du fait du régime statique, aux limites

$$\vec{j} \cdot \vec{n} = 0, \tag{4}$$

où $\vec{n}$ est le vecteur normal à la surface.

La densité de courant est donc surfacique et sera baptisée $k$ dans ce qui suit.

De par la géométrie imposée ici, on adopte le système de coordonnées cylindriques ($\rho$, $\varphi$, z), avec pour origine le centre du cylindre. Le cylindre est ainsi délimité par deux plans de cotes $z = b$ et $z = -b$ et l'axe du cylindre passe par l'origine en constituant son axe de symétrie. L'axe du cylindre est celui de l'aimant de RMN, c'est à dire $Oz$ dans le référentiel du laboratoire.

La distribution de courant prend donc la forme générale

$$\vec{k}(z, \phi) = k_\phi(z, \phi)\vec{u_\phi} + k_z(z, \phi)\vec{u_z} \tag{5}$$

On peut ensuite appliquer la loi de Biot et Savart pour trouver la forme générale de la distribution de champ magnétique induite par les courants. On s'intéresse ici à la composante $B_z$ du champ, qui est la composante dominante dans un aimant de RMN standard. On peut écrire, en utilisant les coordonnées cartésiennes $(x_0, y_0, z_0)$, où $Oz$ est le long de l'axe de l'aimant, pour repérer le point de calcul du champ, et les coordonnées cylindriques pour l'intégration sur la surface portant les courants :

$$B_z(x_0, y_0, z_0) = \frac{\mu_0}{4\pi} \int_{-b}^{b} \int_{-\pi}^{\pi} \frac{(a - x_0 cos\phi - y_0 sin\phi)\, k_\phi(z,\phi)}{(a^2 + x_0^2 + y_0^2 + (z - z_0)^2 - 2a(x_0 cos\phi + y_0 sin\phi))^{\frac{3}{2}}}\, a d\phi dz \qquad (6)$$

Il importe ensuite de définir de manière appropriée le repère (Ox'y'z') dans lequel le DHS est exprimé. Dans le cas d'un échantillon cylindrique 117 tournant, on a tout intérêt à fixer Oz' comme l'axe de révolution de l'échantillon. Il est bien connu que la rotation rapide autour de l'axe Oz' permet d'annuler l'effet des termes non axiaux dans le signal RMN. On se simplifie ainsi la tâche en ne devant ajuster que des termes axiaux. On pourrait parler de repère "propre" de l'échantillon.

Les termes axiaux ne sont autres que les n-dérivées le long de l'axe Oz' calculées à l'origine. On a ainsi

$$Z'_n = \frac{1}{n!} \left( \frac{d^n B_\alpha}{dz'^n} \right)_O \qquad (7)$$

L'indice alpha de B indique la composante de B le long d'un axe d'orientation arbitraire alpha. Alpha peut être par exemple x, y ou z. Dans cette application spécifique où le champ principal pointe le long de l'axe z et tronque les composantes transverses, alpha peut donc être z.

Il est aisé d'exprimer $U_{z'}$ dans le repère (x,y,z) en fonction de son angle d'inclinaison $\theta$ et en supposant cette inclinaison dans le plan xOz. On a ainsi

$$u_{z'} = cos\,\theta\, u_{z0} + sin\,\theta\, u_{x0}. \qquad (8)$$

On peut donc écrire la dérivée le long de Oz' comme

$$\frac{df}{dz'} = cos\theta \frac{df}{dz_0} + sin\theta \frac{df}{dx_0} \qquad (9)$$

Dans le cas de l'angle magique, on trouve ainsi :

$$Z'_n = \frac{\mu_0}{4\pi} \int_{-b}^{b} \int_{-\pi}^{\pi} \zeta_n\, a d\phi dz \qquad (10)$$

$$\zeta_0 = \frac{a}{(a^2 + z^2)^{\frac{3}{2}}} k_\phi(z,\phi) \qquad (11)$$

$$\zeta_1 = \frac{\sqrt{3}}{3} \frac{(3az + \sqrt{2}(2a^2 - z^2)\cos\phi)}{(a^2 + z^2)^{\frac{5}{2}}} k_\phi(z,\phi) \qquad (12)$$

$$\zeta_2 \quad = \quad \frac{1}{2}\frac{a(2z^2 - 3a^2) + 2\sqrt{2}(4za^2 - z^3)\cos\phi + 2a(3a^2 - 2z^2)\cos^2\phi}{(a^2 + z^2)^{\frac{7}{2}}}k_\phi(z,\phi)$$

(13)

$$\zeta_3 = \frac{\sqrt{3}}{3}\left( -\frac{5az(9a^2 - 2z^2)}{(a^2 + z^2)^{\frac{9}{2}}} + \frac{(63\sqrt{2}a^2z^2 - 36\sqrt{2}a^4 - 6\sqrt{2}z^4)}{(a^2 + z^2)^{\frac{9}{2}}}\cos\phi \right.$$

$$\left. + \frac{30az(5a^2 - 2z^2)}{(a^2 + z^2)^{\frac{9}{2}}}\cos^2\phi + \frac{10a^2(4\sqrt{2}a^2 - 3\sqrt{2}z^2)}{(a^2 + z^2)^{\frac{9}{2}}}\cos^3\phi \right)k\phi(z,\phi) \quad (14)$$

Comme cela a été vu plus haut, on a :

$$\vec{\nabla} \cdot \vec{k} = 0, \qquad\qquad (15)$$

Ainsi que

$$\vec{k} \cdot \vec{n} = 0. \qquad\qquad (16)$$

Ces équations impliquent que k est le rotationnel d'un vecteur F tel que

$$\vec{k} = \vec{\nabla} \times \vec{F} \qquad\qquad (17)$$

$$\vec{F} = F(z,\phi)\vec{u}_z \qquad\qquad (18)$$

*F* est appelée fonction flux. On peut alors montrer que l'on obtient la distribution de courant minimisant la puissance dissipée pour une valeur d'un terme axial *Z'n* donné lorsque la fonction *F* est solution d'une équation de Poisson. Le second membre de cette équation est donné par les contraintes fixées sur le profil de champ, c'est à dire les valeurs relatives désirées des termes axiaux *Z'n* (y compris l'annulation de certains termes si nécessaire).

La fonction flux F minimise ainsi une fonction objectif tout en respectant des contraintes. La fonction objectif P' peut être considérée comme proportionnelle à la puissance P dissipée par effet Joule.

On a ainsi les relations suivantes :

$$P = \frac{a}{\sigma e}P'$$

$$P' = \iint_S \left( k_\varphi^2 + k_z^2 \right) d\varphi dz \qquad\qquad (19) \quad (20)$$

où e est l'épaisseur de la couche mince conductrice de conductivité électrique σ.

Il faudra transformer cette expression pour qu'elle ne fasse intervenir que la fonction flux et il faudra faire de même pour les expressions des contraintes. Ces dernières sont les expressions de coefficients du DHS ou de coefficients $Z'_n$ qui doivent prendre des valeurs fixées ou ne pas dépasser en valeur absolue une limite donnée. Comme ils sont relatifs à la composante $B_z$ du champ produit, ils ne dépendent pas de $k_z$ et dépendent linéairement de $k_\varphi$ avec la forme générique suivante :

$$K'_i = \iint_S k_\varphi f_i(\varphi, z)\, d\varphi dz \qquad (21)$$

Une fois la fonction flux F trouvée, il suffit de tracer des iso-contours de cette fonction $F$ espacés de manière régulière entre les bornes de F (en incluant zéro si il y a changement de signe) sur le cylindre pour obtenir, soit la position de boucles décrites par un fil conducteur ou une piste conductrice, soit la position de découpes dans une plaque de conducteur (par exemple du type tôle de cuivre).

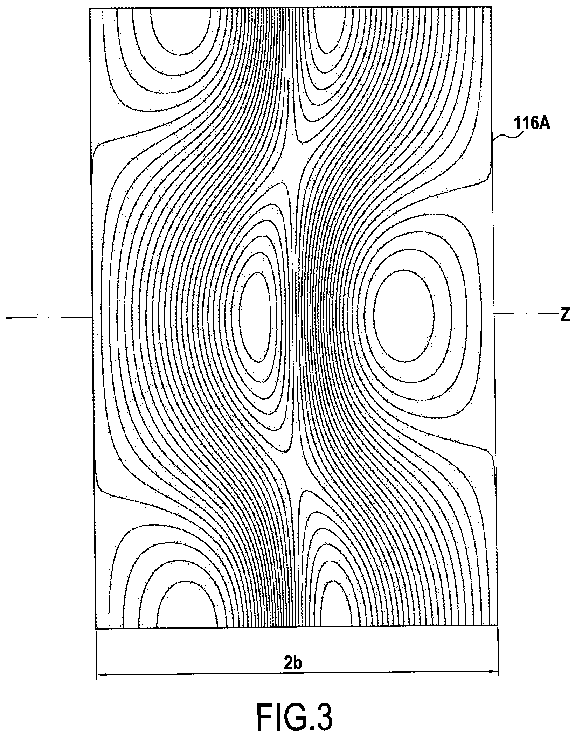

Les figures 3 à 5 montrent des exemples de bobines cylindriques 116A, 116B, 116C générant chacune un profil de champ magnétique dominé par un terme axial $Z'_n$.

Pour chaque figure, Les abscisses correspondent à la direction parallèle à l'axe z du cylindre et les ordonnées à la position angulaire sur le cylindre. Il suffit donc d'enrouler ce dessin autour d'un cylindre de rayon approprié pour obtenir la bobine. Le schéma est à l'échelle et seule la proportion entre le rayon $a$ du cylindre et sa longueur $2b$ doit être conservée constante pour conserver les propriétés calculées (à part l'intensité du terme généré par unité de puissance qui décroît lorsque le rayon $a$ augmente).

La figure 3 montre un exemple de bobine cylindrique 116A générant un profil de champ dominé par $Z'_1$ et dont la puissance dissipée pour une valeur donnée de $Z'_1$ est minimum.

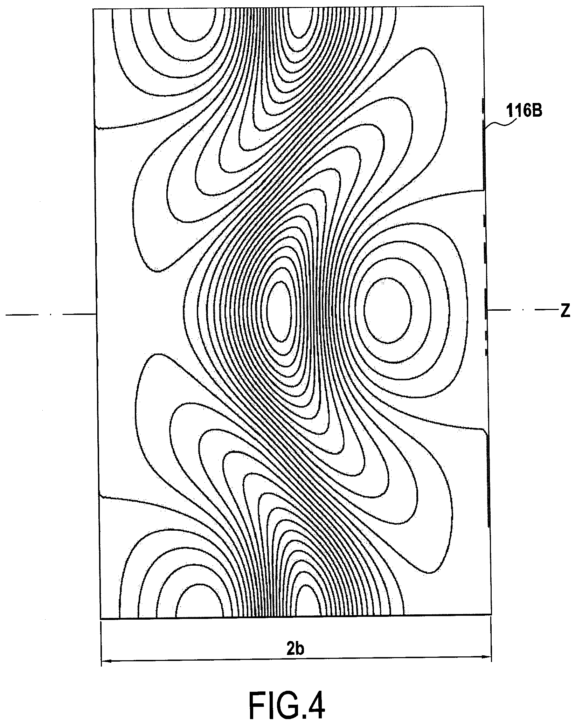

La figure 4 montre un exemple de bobine cylindrique 116B générant un profil de champ dominé par $Z'_2$ et dont la puissance dissipée pour une valeur donnée de $Z'_2$ est minimum.

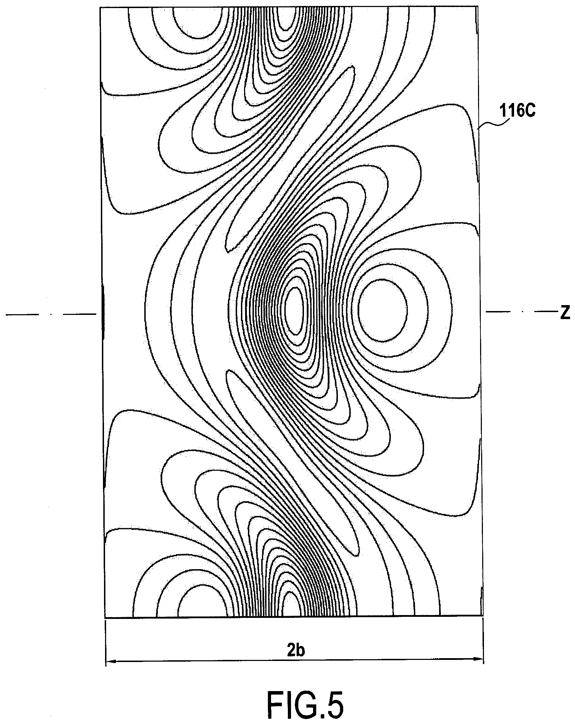

La figure 5 montre un exemple de bobine cylindrique 116C générant un profil de champ dominé par $Z'_3$ et dont la puissance dissipée pour une valeur donnée de $Z'_3$ est minimum.

Pour la réalisation des bobines cylindriques de correction, on peut utiliser par exemple du fil de cuivre isolé de section constante, circulaire ou rectangulaire, collé sur les contours de la fonction de flux. Comme on le voit sur les exemples des figures 3 à 5, il existe un ensemble de différents iso-contours imbriqués les uns dans les autres, à la manière de courbes de niveau. Il convient de passer d'un iso-contour à un iso-contour voisin en ouvrant la boucle et en utilisant un segment de fil droit dont l'emplacement est choisi pour ne pas contribuer au champ principal du dispositif de correction. Ainsi, les boucles fermées des fils conducteurs superposés aux iso-contours sont connectées en série et de préférence les segments de liaison sont disposés parallèlement à l'axe Oz pour qu'ils ne créent pas de champ additionnel dans cette direction.

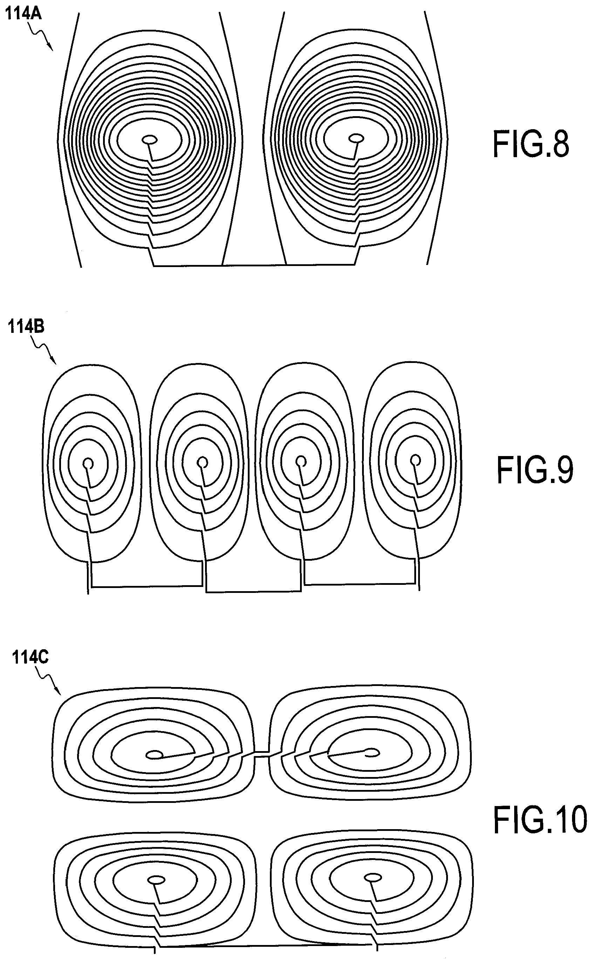

L'invention permet également de réaliser des bobines correctrices de gradient $G_x$, $G_y$, et $G_z$ à partir des iso-contours d'une fonction flux, comme illustré par exemple sur les figures 8 à 10, relatives respectivement à une bobine correctrice de gradient $G_x$, à une bobine correctrice de gradient $G_y$ et à une bobine correctrice de gradient $G_z$. Les figures 8 à 10 représentent respectivement des masques 114A, 114B et 114C pour la réalisation de pistes conductrices sur une face d'un circuit imprimé de manière à constituer des éléments de bobinage pour les gradients $G_x$, $G_y$, et $G_z$. On voit en particulier sur ces masques les passages pour le courant entre les pistes correspondant à des iso-contours voisins, afin de définir des connexions en série. Il est possible d'utiliser un masque sur chacune des faces d'un circuit imprimé afin de doubler l'efficacité de la bobine. Le courant passe d'une face à l'autre par des vias placés au centre des contours du centre. Les bobines correctrices de gradient permettent d'augmenter la linéarité de la variation du champ dans une direction fixée Oz, dans une région d'intérêt, de même que des bobines de correction telles que les bobines de correction 116A, 116B et 116C visent à rendre aussi invariable que possible dans la région d'intérêt le champ magnétique dans la direction Oz.

On a représenté sur la figure 2 un exemple de dispositif de spectroscopie RMN comprenant un boîtier 180 inséré dans le tunnel d'un aimant (non représenté) qui crée dans une zone d'intérêt ZI un champ magnétique homogène $B_0$ ayant une composante axiale orientée selon un axe z 161 du laboratoire.

Un dispositif de mesure 140 comprend un carter 143 relié par des éléments de support 142 au boîtier 180. Le carter 143 contient un échantillon 117 de forme allongée orienté selon un axe z' 141 formant un angle $\theta$ par rapport à l'axe z 161 du champ magnétique principal $B_0$. L'échantillon 117 peut être entraîné en rotation autour de son axe z' (mouvement rotatif 151) par un dispositif 170 d'entraînement en rotation.

On a représenté de façon schématique sur la figure 2 des bobines RF 115 (qui entourent le carter 143 et sont coaxiales avec l'échantillon 117 orienté selon l'axe z' 141), des bobines de gradient 114 (qui ont pour axe l'axe z 161 du laboratoire) et des bobines cylindriques 116 de correction de champ magnétique (de rayon $a$ et de longueur $2b$) dont les caractéristiques sont déterminées de la façon mentionnée plus haut en prenant en considération un repère Ox'y'z' lié à l'échantillon 117 et qui ont pour axe l'axe z 161 du laboratoire.

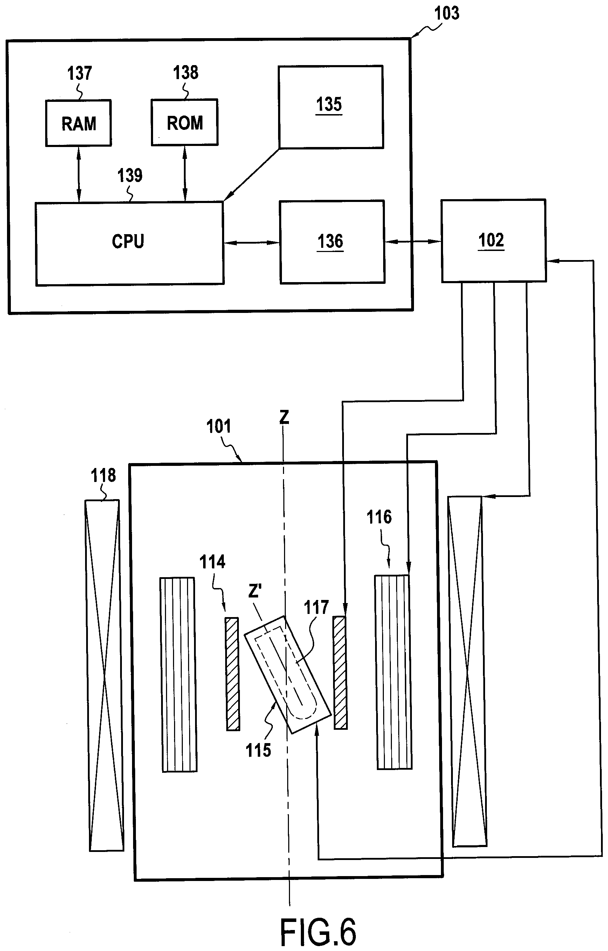

La figure 6 représente de façon schématique l'ensemble d'un système de spectroscopie et d'imagerie par résonance magnétique auquel est applicable l'invention.

Une unité d'expérimentation 101 comprend, à l'intérieur du trou cylindrique d'un aimant 118 de création d'un champ magnétique principal comprenant une composante $B_z$ orientée selon un axe z, de l'extérieur vers l'intérieur, des bobines 116 de correction de champ magnétique coaxiales avec l'axe z), des bobines de gradient 114 (également coaxiales avec l'axe z) et des bobines RF 115 placées au plus près de l'échantillon 117.

L'échantillon 117 de forme allongée selon un axe z' est lui-même incliné d'un angle prédéterminé, par exemple l'angle magique, par rapport à l'axe z, de même que les bobines RF 115 qui entourent l'échantillon 117.

Une unité d'activation 102 alimente les différentes bobines de l'unité d'expérimentation 101 et reçoit également en retour les signaux RF modulés des bobines RF 115.

Une unité de commande 103 qui peut être constituée par un ordinateur comprend un module 136 de communication entre une unité centrale de traitement 139 et l'unité d'activation 102, des unités de mémoires vive 137, des unités de mémoire morte 138 et une interface utilisateur 135. Les valeurs des différents signaux à fournir par l'unité d'activation 102 sont déterminées par l'unité de commande 103.

En résumé, l'espace disponible pour une source de champ magnétique aux caractéristiques données est souvent très limité dans certaines directions et conduit à mettre en oeuvre des distributions de courant sur une surface géométrique imposée. En pratique, ces distributions superficielles sont réalisées de façon approchée soit en disposant des conducteurs filiformes sur la surface, soit par des découpes appropriées de feuilles conductrices minces ou par des techniques de circuits imprimés.

Par exemple, les machines d'imagerie par résonance magnétique (IRM) doivent être munies de sources de gradients de la composante principale du champ magnétique dans trois directions $G_x$, $G_y$, et $G_z$, aussi homogènes que possible. Dans la plupart des machines, les sources de gradients doivent être placées à l'intérieur du cylindre circulaire libre de l'aimant principal et y occuper le minimum de place, ce qui les confine à un espace cylindrique annulaire de faible épaisseur. On peut les réaliser au moyen de bobinages en fil de cuivre de formes appropriées (en hélices pour $G_z$ et en selles de cheval pour $G_x$ ou $G_y$) mais également au moyen de tubes (ou de portions de tube) minces en cuivre dans lesquels on pratique des découpes pour créer des canaux de circulation du courant.

Dans ces mêmes machines ainsi que dans tous les aimants destinés à produire un champ magnétique très homogène dans une région donnée, il est nécessaire de prévoir des dispositifs correcteurs des imperfections du champ résultant d'une réalisation imparfaite des sources (bobinages parcourus par des courants ou matériaux aimantés) ou de perturbations tant externes à l'aimant qu'internes (échantillon et ses supports). Si ces dispositifs appelés « shims » sont réalisés par des courants, la recherche d'un encombrement minimum conduit également à faire appel à des distributions superficielles générant un champ magnétique dont la composante suivant la direction Oz du champ principal présente un profil donné dans la région d'intérêt.

L'invention, qui permet la détermination de densités superficielles de courant portées par un cylindre circulaire générant un profil donné de la composante du champ magnétique suivant l'axe Oz du cylindre, peut être utilisée pour la conception de divers types de systèmes correcteurs ou de générateurs de gradient de champ.

**Revendications**

1. Procédé de correction de champ magnétique d'un système d'imagerie par résonance magnétique, ledit système comprenant un dispositif de création d'un champ magnétique principal selon une direction Oz, dans une zone d'intérêt ZI, un dispositif de support d'un échantillon (117), avec une orientation d'une dimension principale de l'échantillon (117) selon un angle $\theta_0$ différent de zéro par rapport à ladite direction Oz, des bobines de gradient (114), et des bobines radiofréquence (115) et la correction étant effectuée à l'aide de bobines (116) de correction disposées autour dudit dispositif de support de l'échantillon (117), ledit procédé comprenant l'étape suivante:

   - définir un système de coordonnées incliné Ox'y'z' attaché à l'échantillon (117) avec un axe principal Oz' correspondant à ladite dimension principale de l'échantillon (117),

   ledit procédé étant **caractérisé en ce qu'**il comprend en plus les étapes suivantes :

   - déterminer par un développement en harmoniques sphériques dans ledit système de coordonnées incliné Ox'y'z' attaché à l'échantillon (117) la forme des bobines (116) de correction à partir d'une fonction flux F, chaque bobine (116) de correction correspondant à un terme du développement en harmoniques sphériques, et la fonction flux F étant telle que l'on obtient une distribution de courant minimisant la puissance dissipée pour une valeur d'un terme axial $Z'_n$ donné lorsque la fonction F est solution d'une équation de Poisson,
- tracer pour chaque bobine (116) de correction des iso-contours de la fonction flux F espacés de manière régulière entre des bornes de la fonction flux F sur un cylindre en incluant zéro s'il y a changement de signe, et
- former à partir des iso-contours du cylindre de chaque bobine (116) de correction des éléments de bobinage pour définir ladite bobine (116) cylindrique de correction positionnée autour du dispositif de support de l'échantillon (117), l'axe de ladite bobine cylindrique (116) étant confondu avec ladite direction Oz.

2. Procédé selon la revendication 1, **caractérisé en ce que** ledit angle $\theta_0$ différent de zéro correspond à un angle dit magique égal à arctan ($\sqrt{2}$) ~ 54,7°.

3. Procédé selon l'une quelconque des revendications 1 et 2, **caractérisé en ce que** l'on définit des première, deuxième et troisième bobines (116) de correction correspondant respectivement à des termes axiaux $Z'_1$, $Z'_2$, $Z'_3$ du développement en harmoniques sphériques dans ledit système de coordonnées incliné $Ox'y'z'$ attaché à l'échantillon (117).

4. Procédé selon l'une quelconque des revendications 1 à 3, **caractérisé en ce que** l'on alimente chacune des bobines (116) de correction à l'aide d'un courant dont la valeur est ajustable.

5. Dispositif de correction de champ magnétique d'un système d'imagerie par résonance magnétique, ledit système comprenant un dispositif de création d'un champ magnétique principal selon une direction Oz, dans une zone d'intérêt ZI, un dispositif de support d'un échantillon (117), avec une orientation d'une dimension principale de l'échantillon (117) selon un angle $\theta_0$ différent de zéro par rapport à ladite direction principale Oz, des bobines de gradient (114) et des bobines radiofréquence (115), ledit dispositif de correction de champ magnétique comprenant un ensemble de bobines (116) de correction positionnées autour du dispositif de support de l'échantillon (117), **caractérisé en ce que** chaque bobine (116) de correction présente un axe confondu avec la direction Oz et comprend des éléments de bobinage réalisés à partir des iso-contours d'une fonction flux F espacés de manière régulière entre des bornes de la fonction flux F sur un cylindre, la forme des iso-contours étant déterminée à partir d'un développement en harmoniques sphériques dans un système de coordonnées incliné $Ox'y'z'$ attaché à l'échantillon (117) avec un axe principal Oz' correspondant à ladite dimension principale de l'échantillon (117), chaque bobine (116) de correction correspondant à un terme du développement en harmoniques sphériques, la fonction flux F étant telle que l'on obtient une distribution de courant minimisant la puissance dissipée pour une valeur d'un terme axial $Z'_n$ donné lorsque la fonction $F$ est solution d'une équation de Poisson.

6. Dispositif selon la revendication 5, **caractérisé en ce que** ledit angle $\theta_0$ différent de zéro correspond à un angle dit magique égal à arctan ($\sqrt{2}$) ~ 54,7°.

7. Dispositif selon la revendication 5 ou la revendication 6, **caractérisé en ce que** l'ensemble de bobines (116) de correction comprend des première, deuxième et troisième bobines (116) de correction correspondant respectivement à des termes axiaux $Z'_1$, $Z'_2$, $Z'_3$ du développement en harmoniques sphériques dans ledit système de coordonnées incliné $Ox'y'z'$ attaché à l'échantillon (117).

8. Dispositif selon l'une quelconque des revendications 5 à 7, **caractérisé en ce que** les éléments de bobinage des bobines (116) de correction comprennent des pistes ou fils conducteurs sur un support isolant.

9. Système d'imagerie par résonance magnétique, comprenant un dispositif de création d'un champ magnétique principal selon une direction Oz, dans une zone d'intérêt ZI, un dispositif de support d'un échantillon (117), avec une orientation d'une dimension principale de l'échantillon (117) selon un angle $\theta_0$ différent de zéro par rapport à ladite direction Oz, des bobines de gradient (114) et des bobines radiofréquence (115), **caractérisé en ce qu'**il comprend un dispositif de correction de champ magnétique selon l'une quelconque des revendications 5 à 8.

10. Système selon la revendication 9, **caractérisé en ce que** ladite direction Oz est verticale.

11. Système selon la revendication 9, **caractérisé en ce que** ladite direction Oz est horizontale.

**Patentansprüche**

1. Verfahren zur Korrektur eines Magnetfeldes eines Bildgebungssystems durch magnetische Resonanz, wobei das System eine Erzeugungsvorrichtung eines Hauptmagnetfeldes gemäß einer Richtung Oz in einem Bereich von Interesse ZI, eine Trägervorrichtung einer Probe (117) mit einer Ausrichtung einer Hauptabmessung der Probe (117) gemäß einem Winkel $\theta_0$, der sich von Null unterscheidet, im Verhältnis zu der Richtung Oz, Gradientenspulen (114) und Funkfrequenzspulen (115) umfasst, und wobei die Korrektur mit Hilfe der Korrekturspulen (116) vorgenommen wird, die um die Trägervorrichtung der Probe (117) herum angeordnet sind,
wobei das Verfahren den nachfolgenden Schritt umfasst:

- Definieren eines geneigten Koordinatensystems Ox'y'z', das an die Probe (117) gebunden ist, mit einer Hauptachse Oz' entsprechend der Hauptabmessung der Probe (117),

wobei das Verfahren **dadurch gekennzeichnet ist, dass** es darüber hinaus die nachfolgenden Schritte umfasst:

- Bestimmen, durch eine Entwicklung von sphärischen harmonischen Schwingungen in dem geneigten Koordinatensystem Ox'y'z', das an die Probe (117) gebunden ist, der Form der Korrekturspulen (116) ausgehend von einer Flussfunktion F, wobei jede Korrekturspule (116) einem Ausdruck der Entwicklung der sphärischen harmonischen Schwingungen entspricht,
und sich die Flussfunktion F dergestalt darstellt, dass eine Stromverteilung erhalten wird, welche die Verlustleistung für einen Wert eines gegebenen axialen Ausdrucks $Z'_n$ minimiert, wenn es sich bei der Funktion F um die Lösung einer Poisson-Gleichung handelt,
- Skizzieren für jede Korrekturspule (116) der Isokonturen der Flussfunktion F, die auf regelmäßige Weise zwischen den Anschlussklemmen der Flussfunktion F an einem Zylinder beabstandet sind, wobei Null eingeschlossen ist, falls eine Vorzeichenänderung vorkommt, und
- Ausbilden, ausgehend von den Isokonturen des Zylinders jeder Korrekturspulen (116), der Wicklungselemente, um die zylindrische Korrekturspule (116) zu definieren, die um die Trägervorrichtung der Probe (117) herum angeordnet ist, wobei die Achse der zylindrischen Spule (116) mit der Richtung Oz zusammenfällt.

2. Verfahren gemäß Anspruch 1, **dadurch gekennzeichnet, dass** der Winkel $\theta_0$, der sich von Null unterscheidet, einem Winkel, der magisch genannt wird, gleich Arkustangens ($\sqrt{2}$) ~ 54,7° entspricht.

3. Verfahren gemäß irgendeinem der Ansprüche 1 und 2, **dadurch gekennzeichnet, dass** erste, zweite und dritte Korrekturspulen (116) jeweils entsprechend den axialen Ausdrücken $Z'_1$, $Z'_2$, $Z'_3$ der Entwicklung der sphärischen harmonischen Schwingungen in dem geneigten Koordinatensystem Ox'y'z' definiert werden, das an die Probe (117) gebunden ist.

4. Verfahren gemäß irgendeinem der Ansprüche 1 bis 3, **dadurch gekennzeichnet, dass** jede der Korrekturspulen (116) mit Hilfe eines Stromes versorgt wird, dessen Wert einstellbar ist.

5. Korrekturvorrichtung eines Magnetfeldes eines Bildgebungssystems durch magnetische Resonanz, wobei das System eine Erzeugungsvorrichtung eines Hauptmagnetfeldes gemäß einer Richtung Oz in einem in einem Bereich von Interesse ZI, eine Trägervorrichtung einer Probe (117) mit einer Ausrichtung einer Hauptabmessung der Probe (117) gemäß einem Winkel $\theta_0$, der sich von Null unterscheidet, im Verhältnis zu der Hauptrichtung Oz, Gradientenspulen (114) und Funkfrequenzspulen (115) umfasst, und wobei die Korrekturvorrichtung des Magnetfeldes eine Einheit mit Korrekturspulen (116) umfasst, die um die Trägervorrichtung der Probe (117) herum angeordnet sind, **dadurch gekennzeichnet, dass** jede Korrekturspule (116) eine Achse aufweist, die mit der Richtung Oz zusammenfällt und Wicklungselemente umfasst, die ausgehend von Isokonturen einer Flussfunktion F hergestellt sind, die auf regelmäßige Art und Weise zwischen den Anschlussklemmen der Flussfunktion F an einem Zylinder beabstandet sind, wobei die Form der Isokonturen ausgehend von einer Entwicklung von sphärischen harmonischen Schwingungen in einem geneigten Koordinatensystem Ox'y'z', das an die Probe (117) gebunden ist, mit einer Hauptachse Oz' entsprechend der Hauptabmessung der Probe (117) bestimmt wird, wobei jede Korrekturspule (116) einem Ausdruck der Entwicklung der sphärischen harmonischen Schwingungen entspricht, wobei die Flussfunktion F sich dergestalt darstellt, dass eine Stromverteilung erhalten wird, welche die Verlustleistung für einen Wert eines gegebenen axialen Ausdrucks $Z'n$ minimiert, wenn es sich bei der Funktion $F$ um die Lösung einer Poisson-Gleichung handelt.

6. Vorrichtung gemäß Anspruch 5, **dadurch gekennzeichnet, dass** der Winkel $\theta_0$, der sich von Null unterscheidet, einem Winkel, der magisch genannt wird, gleich Arkustangens ($\sqrt{2}$) ~ 54,7° entspricht.

7. Vorrichtung gemäß dem Anspruch 5 oder 6, **dadurch gekennzeichnet, dass** die Einheit von Korrekturspulen (116) erste, zweite und dritte Korrekturspulen (116) jeweils entsprechend den axialen Ausdrücken $Z'_1$, $Z'_2$, $Z'_3$ der Entwicklung der sphärischen harmonischen Schwingungen in dem geneigten Koordinatensystem Ox'y'z' definiert werden, das an die Probe (117) gebunden ist.

8. Vorrichtung gemäß irgendeinem der Ansprüche 5 bis 7, **dadurch gekennzeichnet, dass** die Wicklungselemente der Korrekturspulen (116) Leiterbahnen oder Leitungsdrähte auf einem isolierenden Träger umfassen.

9. Bildgebungssystem durch magnetische Resonanz, umfassend eine Erzeugungsvorrichtung eines Hauptmagnetfeldes gemäß einer Richtung Oz in einem Bereich von Interesse ZI, eine Trägervorrichtung einer Probe (117) mit einer Ausrichtung einer Hauptabmessung der Probe (117) gemäß einem Winkel $\theta_0$, der sich von Null unterscheidet, im Verhältnis zu der Richtung Oz, Gradientenspulen (114) und Funkfrequenzspulen (115), **dadurch gekennzeichnet, dass** es eine Korrekturvorrichtung gemäß irgendeinem der Ansprüche 5 bis 8 umfasst.

10. System gemäß Anspruch 9, **dadurch gekennzeichnet, dass** die Richtung Oz vertikal ist.

11. System gemäß Anspruch 9, **dadurch gekennzeichnet, dass** die Richtung Oz horizontal ist.

**Claims**

1. A method of correcting magnetic field in a magnetic resonance imaging system, said system comprising a device for creating a main magnetic field along a direction Oz in a zone of interest ZI, a device for supporting a sample (117) with a main dimension of the sample (117) being oriented at an angle $\theta_0$ other than zero relative to said direction Oz, gradient coils (114), and radiofrequency coils (115), the correction being performed using correction coils (116) arranged around said device for supporting the sample (117); the method comprising the following step:

   - defining an inclined coordinate system Ox'y'z' attached to the sample (117), with a main axis Oz' corresponding to said main dimension of the sample (117);

   said method being **characterized in that** it further comprises the following steps :

   · using a spherical harmonic development in said inclined coordinate system Ox'y'z' attached to the sample (117) to determine the shape of correction coils (116) from a flux function F, each correction coil (116) corresponding to a term of the spherical harmonic development;
   and the flux function F being such that a current distribution is obtained that minimizes the power dissipated for a value of a given axial term $Z'_n$ when the function F is a solution of a Poisson equation,
   · for each correction coil (116), tracing iso-contours of the flux function F that are regularly spaced apart between the limits of the flux function F on a cylinder and including zero if there is a change of sign; and
   · from the iso-contours of the cylinder of each correction coil (116), forming winding elements in order to define said cylindrical correction coil (116) positioned around the device for supporting the sample (117), the axis of said cylindrical coil (116) coinciding with said direction Oz.

2. A method according to claim 1, **characterized in that** said angle $\theta_0$ other than zero corresponds to a so-called "magic" angle equal to arctan $(\sqrt{2}) \approx 54.7°$.

3. A method according to claim 1 or claim 2, **characterized in that** first, second, and third correction coils (116) are defined corresponding to the axial terms $Z'_1$, $Z'_2$, $Z'_3$ of the spherical harmonic development in said inclined coordinate system Ox'y'z' attached to the sample (117).

4. A method according to any one of claims 1 to 3, **characterized in that** each of the correction coils (116) is powered with a current of adjustable value.

5. A device for magnetic field correction in a magnetic resonance imaging system, said system comprising a device for creating a main magnetic field along a direction Oz in a zone of interest ZI, a device for supporting a sample (117) with a main dimension of the sample (117) being oriented at an angle $\theta_0$ other than zero relative to said direction Oz, gradient coils (114), and radiofrequency coils (115), said device for magnetic field correction comprising a set of correction coils (116) positioned around the device for supporting the sample (117), the device being **characterized in that** each correction coil (116) presents an axis coinciding with the direction Oz and comprises winding elements made from iso-contours of a flux function F that are regularly spaced apart between limits of the flux function F on a cylinder, the shape of the iso-contours being determined from a spherical harmonic development in an inclined coordinate system Ox'y'z' attached to the sample (117) with a main axis Oz' corresponding to said main dimension of the sample (117), each correction coil (116) corresponding to a term of the spherical harmonic development, the flux function F being such as to obtain a current distribution that minimizes the power dissipated for a value of a given axial term $Z'_n$ when the function $F$ is a solution of a Poisson equation.

6. A device according to claim 5, **characterized in that** said angle $\theta_0$ other than zero corresponds to a so-called "magic" angle equal to arctan($\sqrt{2}$) $\approx$ 54.7°.

7. A device according to claim 5 or claim 6, **characterized in that** the set of correction coils (116) comprises first, second, and third correction coils (116) corresponding respectively to the axial terms $Z'_1$, $Z'_2$, $Z'_3$ of the spherical harmonic development in said inclined coordinate system Ox'y'z' attached to the sample (117).

8. A device according to any one of claims 5 to 7, **characterized in that** the winding elements of the correction coils (116) comprise conductive tracks or wires on an insulating support.

9. A magnetic resonance imaging system, comprising a device for creating a main magnetic field along a direction Oz in a zone of interest ZI, a device for supporting a sample (117) with a main dimension of the sample (117) being oriented at an angle $\theta_0$ other than zero relative to said direction Oz, gradient coils (114), and radiofrequency coils (115), the device being **characterized in that** it includes a magnetic field correction device according to any one of claims 5 to 8.

10. A system according to claim 9, **characterized in that** said direction Oz is vertical.

11. A system according to claim 9, **characterized in that** said direction Oz is horizontal.

$B_0 = B_z$

117

z'

x'

$\omega_r$

y'

$\theta_m$

x

y

z

$G_z = dB_0/dz' = dB_z/dz'$

z'

## FIG.1

$B_0 = B_z$

z

$\omega_r$

17

x

y

$G_z = dB_0/dz = dB_z/dz$      $G_x = dB_0/dx = dB_z/dx$      $G_y = dB_0/dy = dB_z/dy$

## FIG.11
## ART ANTERIEUR

15

FIG.2

FIG.3

FIG.4

**FIG.5**

FIG.6

FIG.7

EP 2 959 305 B1

114A

FIG.8

114B

FIG.9

114C

FIG.10